# EUROPÄISCHE PATENTSCHRIFT

(11) **EP 1 672 788 B1**
(45) Veröffentlichungstag und Bekanntmachung des Hinweises auf die Patenterteilung: **05.09.2007**
(21) Anmeldenummer: 04293040.4
(22) Anmeldetag: 17.12.2004
(51) Int. Cl.: H03H 7/01

(54) **Siebschaltung**
Low pass filter for battery charging circuit
Filtre passe bas pour circuit de chargement de batteries

(43) Veröffentlichungstag der Anmeldung: 21.06.2006
(73) Patentinhaber: Thales Security Solutions & Services GmbH, 70435 Stuttgart (DE)
(72) Erfinder: Telefont, Heinz, 3500 Krems-Egelsee (AT); Schimkowitsch, Manfred, 1210 Wien (AT)
(74) Vertreter: Kohler Schmid Möbus

(56) Entgegenhaltungen:
- DE-A1- 2 511 718
- US-B1- 6 646 406
- LAKSHMINARASAMMA N ET AL: "A unified model for the ZVS DC-DC converters with active clamp" POWER ELECTRONICS SPECIALISTS CONFERENCE, 2004. PESC 04. 2004 IEEE 35TH ANNUAL AACHEN, GERMANY 20-25 JUNE 2004, PISCATAWAY, NJ, USA,IEEE, US, Bd. 3, 20. Juni 2004 (2004-06-20), Seiten 2441-2447, XP010739657 ISBN: 0-7803-8399-0

## Beschreibung

Die Erfindung betrifft eine Siebschaltung mit einem Tiefpassfilter und eine Schaltungsanordnung mit der Siebschaltung.

### Stand der Technik

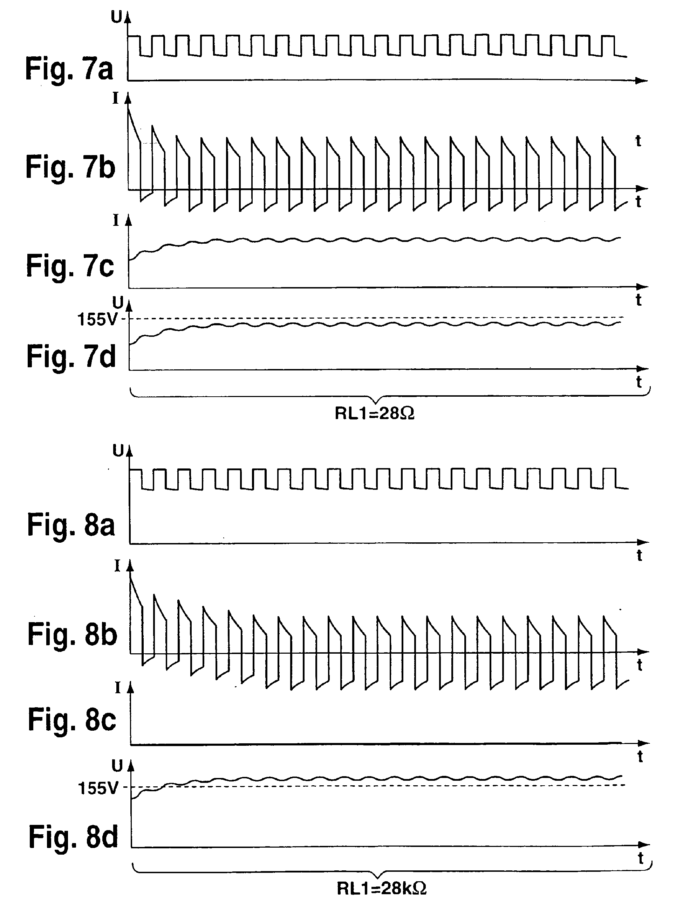

Siebschaltungen, insbesondere für Batterie-Ladeschaltungen, sind verschiedentlich bekannt und werden z.B. in Triebfahrzeugen für die Eisenbahn verwendet. **Fig. 6** zeigt ein Blockschaltbild einer Batterie-Ladeschaltung 1 mit einer Batterie **2,** welche eine Nominalspannung von 110 V erzeugt und einen Innenwiderstand **R1** aufweist. Die Batterie 2 des Triebfahrzeuges wird über den Laderegler des Bordnetzes geladen, der in dem Blockschaltbild durch einen idealen Generator A und eine Diode **D1** dargestellt ist und die Batterie mit einer pulsierenden Gleichspannung (Rechteckspannung) mit einem Maximalwert von 230 V bei 50 Hz auflädt.

Die Rechteck-Spannung **U** mit einem Maximalwert von 230 V am Punkt **B** der Batterie-Ladeschaltung 1 ist in **Fig. 7a** in Abhängigkeit von der Zeit gezeigt, der Strom **I** am Punkt **J** der Batterie-Ladeschaltung 1 in **Fig. 7b.**

Eine Siebschaltung **3** nach dem Stand der Technik für die Batterie-Ladeschaltung 1 ist ebenfalls in **Fig. 6** gezeigt. Die Siebschaltung 3 umfasst einen Tiefpassfliter **5** mit einem ersten Kondensator **C1** mit einer Kapazität von 4700 µF und einem ersten Widerstand **R3** von 2,5 Ω. Dem Tiefpassfilter 5 ist ein zweiter, identisch aufgebauter Tiefpassfilter **4** mit einem zweiten Kondensator **C2** und einem zweiten Widerstand **R2** in Reihe vorgeschaltet, welche dieselbe Kapazität wie der erste Kondensator C1 bzw. denselben Widerstandswert wie der erste Widerstand R3 aufweisen. Eine sich am Ausgang der Siebschaltung 3 anschließende Elektronik ist im Blockschaltbild von Fig. 6 durch einen dem Eingangswiderstand der Elektronik entsprechenden Lastwiderstand **RL1** dargestellt. Die Siebschaltung 3 dient der Glättung der von der Batterie-Ladeschaltung 1 gelieferten Spannung.

Die gemessene Ausgangsspannung U der Siebschaltung 3 am Punkt **C** ist in **Fig. 7d,** der gemessene Ausgangsstrom I am Punkt **K** in **Fig. 7c** für einen Lastwiderstand RL1 von 28 Ω gezeigt. Der Maximalwert der Ausgangsspannung am Punkt C hat bei einem maximalen Strom von 5,53 A einen Wert von 155 V. Für die auf die Siebschaltung 3 folgende Elektronik ist die Ausgangsspannung der Siebschaltung 3 die relevante Größe, denn die Elektronik verträgt im vorliegenden Fall eine maximale Spannung von 155 V (gestrichelte Linie in Fig. 7d). Eine weitere Erhöhung der Ausgangsspannung der Siebschaltung 3 sollte daher auch bei stärkerer Belastung der Siebschaltung 3, bedingt durch einen größeren Eingangswiderstand der Elektronik, vermieden werden.

Die Ausgangsspannung der Siebschaltung 3 am Punkt C für einen auf 28 kΩ erhöhten (im Vergleich zu Fig. 7 um einen Faktor 1000 vergrößerten) Lastwiderstand RL1 ist in **Fig. 8d,** der Ausgangsstrom an Punkt K in **Fig. 8c** gezeigt. Die maximale Ausgangsspannung am Punkt C beträgt 186 V, der maximale Strom an Punkt K beträgt nur 6,65 mA, weshalb er in **Fig. 8c** aufgrund des gewählten Maßstabs durch eine waagrechte Linie bei der Nulllinie dargestellt ist. Die in **Fig. 8b** gezeigte Stromstärke am Punkt J verringert sich im Vergleich zur maximalen Stromstärke von 19,1 A von Fig. 7b auf maximal 12,5 A, wohingegen die maximale Spannung am Punkt B sowohl in Fig. 7a als auch **Fig. 8a** bei maximal 230 V liegt.

Problematisch ist hierbei für die auf die Siebschaltung 3 folgende Elektronik, dass deren maximal tolerierte Eingansspannung von 155 V bei einem Lastwiderstand RL1 (Eingangswiderstand) von 28 kΩ mit der Ausgangsspannung von 186 V (Fig. 8d) überschritten wird. Mit der Siebschaltung 3 ist es nicht möglich, die in einem großen Bereich schwankende Eingangsspannung von der Batterie-Ladeschaltung 1 in eine stabilisierte Ausgangsspannung umzuwandeln.

### Aufgabe der Erfindung

Aufgabe der Erfindung ist es, eine Siebschaltung bereitzustellen, die eine stark schwankende Eingangsspannung verlustarm in eine Ausgangsspannung mit einer möglichst lastunabhängigen Maximalspannung umwandelt.

### Gegenstand der Erfindung

Gelöst wird diese Aufgabe erfindungsgemäß durch eine Schaltungsanordnung gemäß Anspruch 1.

Die im Tiefpassfilter gespeicherte Energie wird über die Rückstromdiode an den Spannungseingang des Tiefpassfilters zurückgeführt und damit die Ausgangsspannung stabilisiert, wobei gleichzeitig die Stoßspannungsfestigkeit und die HF-Siebung verbessert werden.

Bei einer vorteilhaften Ausführungsform umfassen der oder die Tiefpassfilter mindestens einen Widerstand und mindestens einen Kondensator. Derart aufgebaute Tiefpassfilter ermöglichen eine besonders vorteilhafte Rückkopplung über die Rückstromdiode.

Bei einer bevorzugten Ausführungsform umfassen der oder die Tiefpassfilter eine Drossel. Die Drossel ist typischerweise ein Wickelgut, z.B. eine Drosselspule, und dient der Verringerung der durch die Rückstromdiode verstärkten Ausgangswelligkeit der Ausgangsspannung der Siebschaltung.

Bei einer besonders bevorzugten Ausführungsform sind der Tiefpassfilter und der weitere Tiefpassfilter identisch aufgebaut. Hierdurch kann die Zahl der Bauteiltypen und der Bauteilgrößen der für die Schaltung benötigten Bauteile reduziert werden.

Die Erfindung betrifft auch eine Schaltungsanordnung mit einer wie oben beschriebenen Siebschaltung und einer Batterie-Ladeschaltung, die eine Batterie und einen Gleichstrom-Generator umfasst. Der Gleichstrom-Generator erzeugt eine Rechteckspannung zum Laden der Batterie. Die Eingangsspannung der Siebschaltung entspricht somit der Nominalspannung der Batterie, welcher die Rechteckspannung des Generators überlagert ist.

Bei einer Ausführungsform ist der Innenwiderstand der Rückstromdiode an den Innenwiderstand der Batterie derart angepasst, dass ein maximaler Strom durch die Rückstromdiode nicht überschritten wird. Bei Überschreitung des maximalen Stroms durch die Rückstromdiode könnte diese zerstört werden.

Weitere Merkmale und Vorteile der Erfindung ergeben sich aus der nachfolgenden Beschreibung eines Ausführungsbeispiels der Erfindung, anhand der Figuren der Zeichnung, die erfindungswesentliche Einzelheiten zeigen, und aus den Ansprüchen. Die einzelnen Merkmale können je einzeln für sich oder zu mehreren in beliebiger Kombination bei einer Variante der Erfindung verwirklicht sein.

### Zeichnung

Ein Ausführungsbeispiel ist in der schematischen Zeichnung dargestellt und wird in der nachfolgenden Beschreibung erläutert. Es zeigt:
- Fig. 1: eine Ausführungsform einer Schaltungsanordnung mit einer Batterie-Ladeschaltung und einer erfindungsgemäßen Siebschaltung mit Rückstromdiode;
- Fig. 2: in vier Teilbildern a-d eine Darstellung des Strom- und Spannungsverlaufs am Ausgang der Batterie-Ladeschaltung und der Siebschaltung von Fig. 1 bei einer Belastung mit einem Widerstand von 28 Ω;
- Fig. 3: eine Fig. 2 entsprechende Darstellung bei einer Belastung mit einem Widerstand von 28 kΩ;
- Fig. 4: in vier Teilbildern a-d eine Darstellung des Strom- und Spannungsverlaufs am Ausgang der Batterie-Ladeschaltung und der Siebschaltung von Fig. 1 ohne Rückkopplung durch eine Rückstromdiode bei einer Belastung mit einem Widerstand von 28 Ω;

- Fig. 5: eine Fig. 4 entsprechende Darstellung bei einer Belastung mit einem Widerstand von 28 kΩ;
- Fig. 6: eine Schaltungsanordnung mit einer Batterie-Ladeschaltung und einer Siebschaltung nach dem Stand der Technik;
- Fig. 7: in vier Teilbildern a-d eine Darstellung des Strom- und Spannungsverlaufs am Ausgang der Batterie-Ladeschaltung und der Siebschaltung von Fig. 6 bei einer Belastung mit einem Widerstand von 28 Ω; und
- Fig. 8: eine Fig. 7 entsprechende Darstellung bei einer Belastung mit einem Widerstand von 28 kΩ.

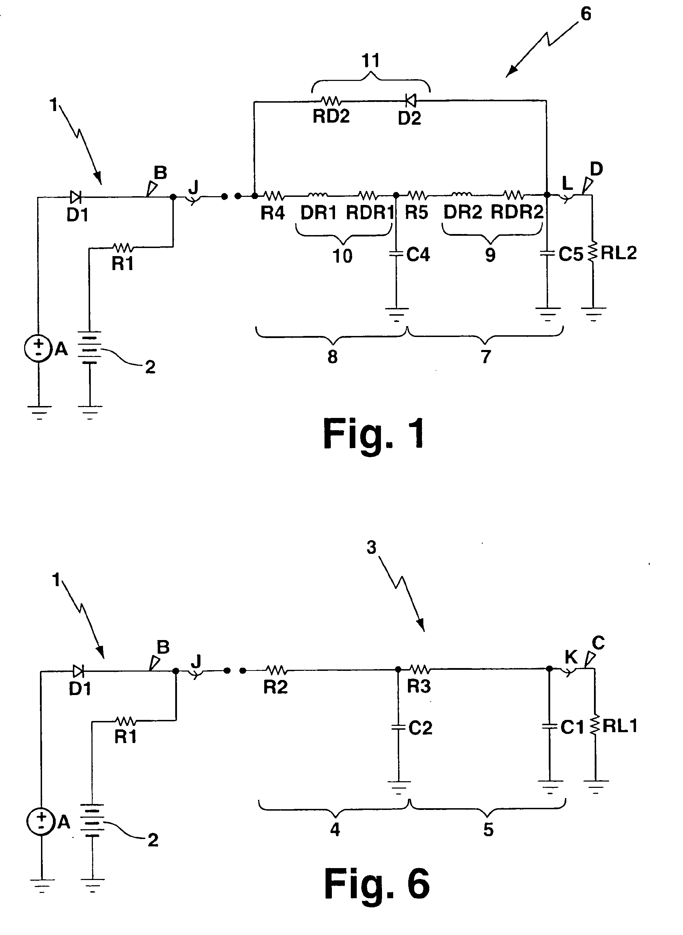

**Fig. 1** zeigt ein Blockschaltbild einer Schaltungsanordnung mit einer Batterie-Ladeschaltung 1 (vgl. Fig. 6) und einer Siebschaltung **6** mit einem Tiefpassfilter **7,** der einen Kondensator **C5** mit 4700 µF und einen Widerstand **R5** von 2,0 Ω aufweist. In Reihe zu dem Widerstand R5 ist eine Spule als Drossel **9** angeordnet, welche im Blockschaltbild durch eine Induktivität **DR2** von 13 mH und einen Innenwiderstand **RDR2** von 0,5 Ω dargestellt ist. Ein weiterer, identisch aufgebauter Tiefpassfilter **8** ist dem Tiefpassfilter 7 vorgeschaltet und weist einen weiteren Kondensator **C4** und einen weiteren Widerstand **R4** sowie eine weitere Drossel **10** auf, welche aus einem Innenwiderstand **RDR1** und einer Induktivität **DR1** besteht. Die Drosseln 9, 10 dienen der Reduktion der Welligkeit der Ausgangsspannung der Siebschaltung 6.

Zwischen dem Ausgang des Tiefpassfilters 7 und dem Eingang des weiteren Tiefpassfilters **8** ist eine Rückstromdiode **11** angeordnet, welche im Blockschaltbild durch eine ideale Diode **D2** und einen Diodenwiderstand RD2 dargestellt ist. Die Rückstromdiode 11 ist so geschaltet, dass sie einen Stromfluss vom Ausgang des Tiefpassfilters 7 zum Eingang des weiteren Tiefpassfilters 8 ermöglicht, wobei sie gleichzeitig einen Stromfluss in die Gegenrichtung verhindert. Eine auf die Siebschaltung 6 folgende Elektronik ist durch einen Eingangswiderstand **RL2** dargestellt.

Der Diodenwiderstand RD2 begrenzt den Rückfluss des Stroms und ist an den Innenwiderstand R1 der Batterie 2 der Batterie-Ladeschaltung 1 angepasst, sodass der maximale Strom der Rückstromdiode nicht überschritten wird.

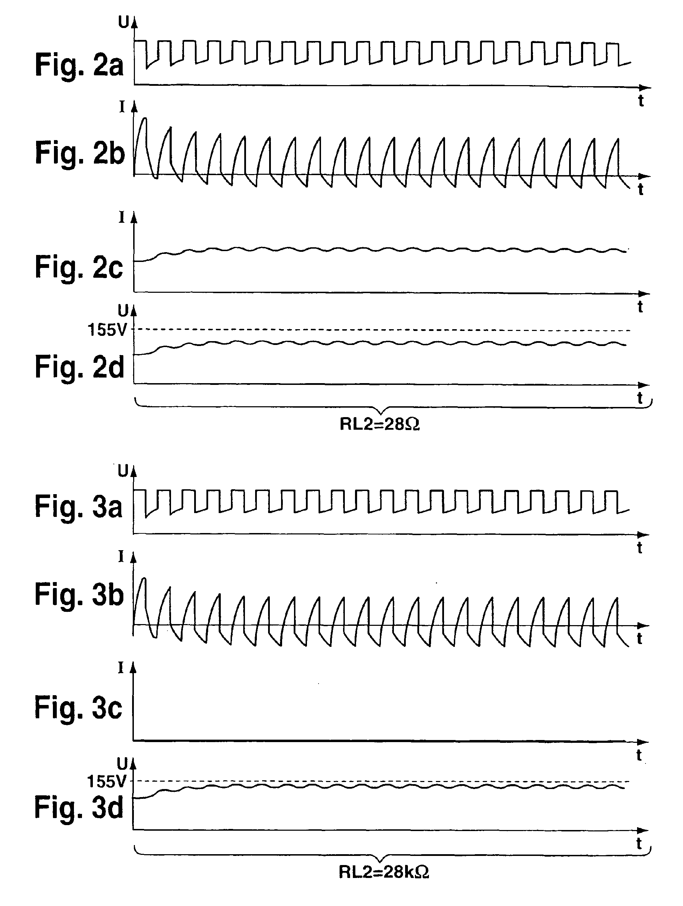

In **Fig. 2** sind für einen Lastwiderstand RL2 von 28 Ω der Spannungsverlauf an Punkt B (**Fig. 2a**) und der Stromverlauf an Punkt J **(Fig. 2b)** am Ausgang der Batterie-Ladeschaltung 1 sowie der Stromverlauf an Punkt L **(Fig. 2c**) und der Spannungsverlauf an Punkt **D (Fig. 2d)** am Ausgang der Siebschaltung 6 gezeigt. Die maximale Spannung an Punkt D liegt bei einem Wert von 135 V, also deutlich unterhalb der Grenze von 155 V, bei der die nachfolgende Elektronik zu stark belastet wird.

**Fig. 3** zeigt die Ströme (Fign. 3b und 3c) und Spannungen (Fign. 3a und 3d) an den Punkten B, J sowie L, D bei einem erhöhten Lastwiderstand RL2 von 28 kΩ. Auch bei erhöhtem Lastwiderstand RL2 weist die Spannung an Punkt D nur einen Maximalwert von 155 V auf und liegt somit im von der nachfolgenden Elektronik tolerierten Bereich.

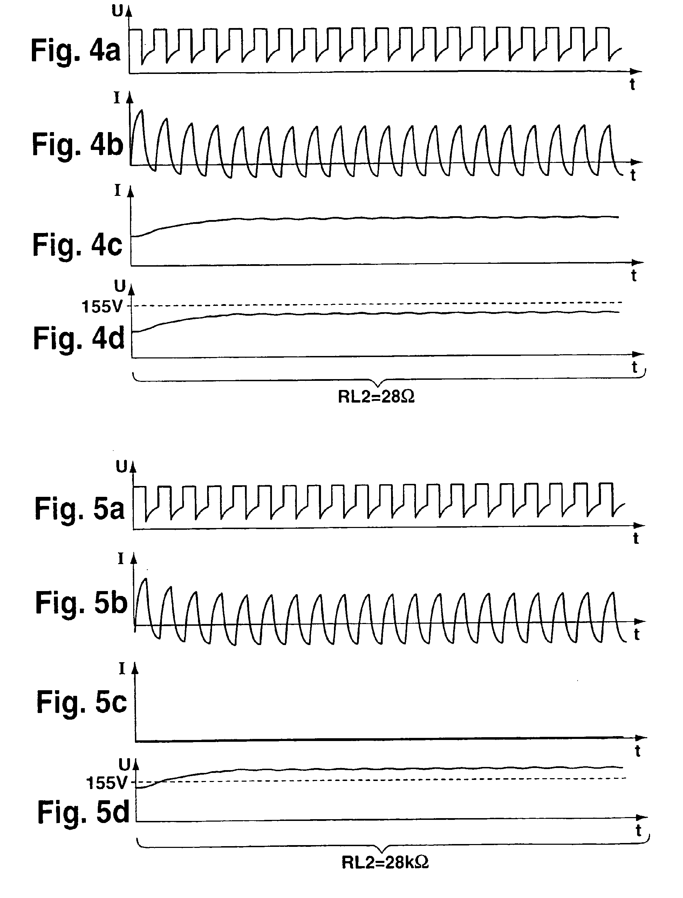

**Fig. 4** und **Fig. 5** zeigen die Ströme (Fign. 4b, 4c und 5b, 5c) und Spannungen (Fign. 4a, 4d und 5a, 5d) an den Punkten B, J bzw. L, D jeweils für eine mit einem Lastwiderstand von 28 Ω bzw. 28 kΩ belastete Siebschaltung 6, wenn die Rückkopplung durch die Rückstromdiode 11 nicht vorhanden ist. Der Maximalwert der Spannung an Punkt D liegt beim Lastwiderstand von 28 Ω bei 144 V (vgl. Fig. 4d), beim Lastwiderstand von 28 kΩ bei 175 V (vgl. Fig. 5d).

Durch den Vergleich der maximalen Spannungswerte an Punkt D in Fig. 3d und 4d mit den Werten von Fig. 5d und 6d wird deutlich, dass durch die Rückkopplung mit der Rückstromdiode 11 der Spannungswert am Punkt D reduziert ist und die Eingangsspannung für die nachfolgende Elektronik in ihrem Anstieg begrenzt ist, wenn eine erhebliche Vergrößerung des Lastwiderstands RL2 vorgenommen wird. Dieses Ergebnis kann durch die Rückstromdiode 11 erreicht werden, ohne dass ein erheblicher zusätzlicher Schaltungsaufwand bzw. eine aktive Elektronik notwendig ist. Die Siebschaltung 6 ermöglicht neben der Glättung der Ausgangsspannung somit auf einfache Weise auch eine Stabilisierung der Ausgangsspannung.

## Patentansprüche

1. Schaltungsanordnung mit einem Gleichstrom-Generator (A) und einer Siebschaltung (6) mit einem Tiefpassfilter (7) und einem dem Tiefpassfilter (7) vorgeschalteten, weiteren Tiefpassfilter (8) sowie einer Rückstromdiode (11),
**dadurch gekennzeichnet,**
**dass** der Ausgang des Tiefpassfilters (7) über die Rückstromdiode (11) mit dem Eingang des weiteren Tiefpassfilters (8) rückgekoppelt ist und die Schaltungsanordnung eine Batterie-Ladeschaltung (1) mit einer Batterie (2) und dem Gleichstrom-Generator (A) umfasst.

2. Schaltungsanordnung nach Anspruch 1, **dadurch gekennzeichnet, dass** die Tiefpassfilter (7, 8) jeweils mindestens einen Widerstand (R4, R5) und mindestens einen Kondensator (C4, C5) umfassen.

3. Schaltungsanordnung nach Anspruch 1, **dadurch gekennzeichnet, dass** die Tiefpassfilter (7, 8) jeweils eine Drossel (9, 10) umfassen.

4. Schaltungsanordnung nach Anspruch 1, **dadurch gekennzeichnet, dass** der Tiefpassfilter (7) und der weitere Tiefpassfilter (8) identisch aufgebaut sind.

5. Schaltungsanordnung nach Anspruch 1, **dadurch gekennzeichnet, dass** ein Innenwiderstand (RD2) der Rückstromdiode (11) an einen Innenwiderstand (R1) der Batterie (2) derart angepasst ist, dass ein maximaler Strom durch die Rückstromdiode (11) nicht überschritten wird.

## Claims

1. Circuit arrangement comprising a direct-current generator (A) and a filter circuit (6) which comprises a low-pass filter (7) and an additional low-pass filter (8) connected on the line side of the low-pass filter (7) and a reverse current diode (11), **characterised in that** the output of the low-pass filter (7) is fed back via the reverse current diode (11) to the input of the additional low-pass filter (8) and the circuit arrangement comprises a battery charging circuit (1) with a battery (2) and the direct-current generator (A).

2. Circuit arrangement according to claim 1, **characterised in that** the low-pass filters (7, 8) each comprise at least one resistor (R4, R5) and at least one capacitor (C4, C5).

3. Circuit arrangement according to claim 1, **characterised in that** the low-pass filters (7, 8) each comprise a choke (9, 10).

4. Circuit arrangement according to claim 1, **characterised in that** the low-pass filter (7) and the additional low-pass filter (8) are identically configured.

5. Circuit arrangement according to claim 1, **characterised in that** an internal resistance (RD2) of the reverse current diode (11) is matched to an internal resistance (R1) of the battery (2) in such a manner that a maximum current through the reverse current diode (11) is not exceeded.

## Revendications

1. Circuit comportant un générateur de courant continu (A) et un circuit de filtrage (6) avec un filtre passe-bas (7) et un autre filtre passe-bas (8) monté en amont du filtre passe-bas (7), ainsi qu'une diode de retour de courant (11),
**caractérisé en ce que**,
la sortie du filtre passe-bas (7) est rétrocouplé, via la diode de courant de retour (11), avec l'entrée de l'autre filtre passe-bas (8) et **en ce que** la configuration du circuit comporte un commutateur de charge de batterie (1) avec une batterie (2) et le générateur de courant continu (A).

2. Circuit selon la revendication 1, **caractérisée en ce que** les filtres passe-bas (7,8) comportent au moins une résistance (R4, R5) et au moins un condensateur (C4, C5).

3. Circuit selon la revendication 1, **caractérisée en ce que** les filtres passe-bas (7,8) comportent une bobine (9,10).

4. Circuit selon la revendication 1, **caractérisée en ce que** le filtre passe-bas (7) et l'autre filtre passe-bas (8) sont de construction identique.

5. Circuit selon la revendication 1, **caractérisée en ce que** une résistance interne (RD2) de la diode de courant de retour (11) est adaptée à une résistance interne (R1) de la batterie (2) de façon telle, qu'il ne puisse pas se produire de dépassement de courant maximal dans la diode de courant de retour (11).
